(19) Europäisches Patentamt

European Patent Office

Office européen des brevets

(11) **EP 0 827 082 B1**

(12) **EUROPEAN PATENT SPECIFICATION**

(45) Date of publication and mention
of the grant of the patent:
**09.08.2006 Bulletin 2006/32**

(51) Int Cl.:
***G06F 12/00*** (2006.01)   ***H04N 1/387*** (2006.01)
***G11C 7/00*** (2006.01)

(21) Application number: **96912269.6**

(22) Date of filing: **26.04.1996**

(86) International application number:
**PCT/JP1996/001166**

(87) International publication number:
**WO 1996/035992 (14.11.1996 Gazette 1996/50)**

(54) **SEMICONDUCTOR MEMORY HAVING ARITHMETIC FUNCTION**

HALBLEITERSPEICHER MIT ARITHMETIKFUNKTION

MEMOIRE A SEMI-CONDUCTEURS INTEGRANT UNE FONCTION ARITHMETIQUE

(84) Designated Contracting States:
**DE FR GB**

(30) Priority: **11.05.1995   JP   11282595**

(43) Date of publication of application:
**04.03.1998   Bulletin 1998/10**

(73) Proprietor: **Hitachi, Ltd.**
**Chiyoda-ku,**
**Tokyo 101 (JP)**

(72) Inventors:
• **FUJITA, Ryo**
**Naka-gun,**
**Ibaraki 319-11 (JP)**

• **SOGA, Mitsuru**
**Kitakanbara-gun,**
**Niigata 959-26 (JP)**
• **NAKATSUKA, Yasuhiro,**
**Keio Koganei Mansion**
**Koganei-shi,**
**Tokyo 184 (JP)**

(74) Representative: **Calderbank, Thomas Roger et al**
**Mewburn Ellis LLP**
**York House**
**23 Kingsway**
**London WC2B 6HP (GB)**

(56) References cited:
**JP-A- 1 321 574        JP-A- 4 031 939**
**JP-A- 5 012 326**

**Description**

Technical Field

The present invention relates to a display apparatus for performing pixel density conversion processing such as enlargement, reduction, and rotation on an original image and displaying a resultant image or to an image processing apparatus and, more particularly, to a processing apparatus for performing a high-speed filtering operation such as data interpolation, which is pixel density conversion processing, and to a memory having arithmetic function for use in the high-speed filtering operation.

Background Art

A conventional display apparatus for performing enlargement, reduction, and rotation on an image is used in texture mapping apparatuses such as disclosed in Japanese Non-examined Patent Publication Nos. Hei 5-298455 and Hei 5-307610. In these publications, methods are disclosed in which, since the coordinate value of an original image corresponding to its destination does not match the center of a pixel of the original image, the value of the pixel of a specified coordinate is estimated by interpolation of pixels around the specified pixel. For enlargement of a binary character image, Japanese Non-examined Patent Publication No. Sho 59-6626 discloses a method of obtaining destination pixels fast enlarged from plural pixels of an original image. In addition, for image differentiation and integration in image processing, a method is well known in which a product-sum operation is performed by weighting surrounding eight pixels.

The conventional processing apparatus such as mentioned above for reading plural pixels from an original image for arithmetic operations has plural memory devices and arithmetic units arranged in parallel to perform parallel processing for high-speed processing.

However, when arranging plural memory devices and reading data at high speeds from an original image for processing, the above-mentioned prior-art technologies present a problem of significantly increasing the number of signal lines between the processor for performing that processing and the plural memory devices. For example, if one pixel consists of 24 bits (red, green, and blue consisting of eight bits each) and an arithmetic operation is performed from an original image consisting of four pixels, 96 bits of data lines are required. Data reading performance of a memory device itself, if the same is an ordinary random access memory, is currently limited to 150 ns in a random access operation. IN order to achieve a target performance, this access speed must be further increased by parallel processing, which in turn increase the number of signal lines still further. This inevitably increases equipment scale as well as equipment cost because the individual performance (operating frequency) needs to be increased.

JP-A-5012326 describes a memory used to perform interpolation processing at a high speed and to decrease the number of components for the interpolation processing. The memory (100) comprising address arithmetic means (10), coefficient operation means (20), storage means (30), interpolation operation means (40) and control means (50), which receives addresses comprising an integer part (input a) and a decimal part (input h), accesses stored data according to the integer part of the address, calculates coefficients based on the decimal part and outputs the interpolated result to a data input/output terminal (3). This memory solves the problem of providing semiconductor memories having arithmetic function for the neighbouring pixels, such that only the data of one pixel need to be transferred to the host processor.

The present invention provides a semiconductor memory having arithmetic function used with a processor, said semi-conductor memory comprising :

a storage means for hold data corresponding to integer addresses in a continuous N-dimensional space (N being an integer);
a data arithmetic means for receiving an input fraction address being composed of an integer component which is the N-dimensional integer address and an N-dimensional fraction component for specifying an address between the integer addresses, and for reading the data corresponding to the address indicated by the integer component, and the data before and after the address indicated by the integer component in each dimension, and for performing arithmetical interpolation according to the fraction component;
a memory control unit for controlling the access of data into the storage means;
an output means for outputting the arithmetic result of the data arithmetic means; wherein,
the data arithmetic means is arranged to calculate interpolation data corresponding to the continuously inputted fraction address, and outputs the calculated result; and wherein:
the output means is arranged to output the calculated result, that is calculated by the data arithmetic means, on the output of a signal, which indicates that arithmetic processing of the data arithmetic means has finished and the input of a signal, which indicates that the processor begins to read an arithmetic result.

The present invention will now be described in detail by way of example, with reference to the accompanying drawings, in which;

FIG. 1 is a block diagram illustrating a semiconductor memory having arithmetic function practiced as one embodiment of the present invention;
FIG. 2 is a diagram illustrating some functions of the semiconductor memory having arithmetic function;
FIG. 3 is a diagram illustrating a processing apparatus using a plurality of semiconductor memories having arithmetic function;
FIG. 4 is a block diagram illustrating an input data buffer block shown in FIG. 1;
FIG. 5 is a block diagram illustrating a command processing block shown in FIG. 1;
FIG. 6 is a block diagram illustrating a pixel processing block shown in FIG. 1;
FIG. 7 is a block diagram illustrating a memory cell shown in FIG. 1; and

FIG. 8 is a block diagram illustrating an output data buffer block shown in FIG. 1.

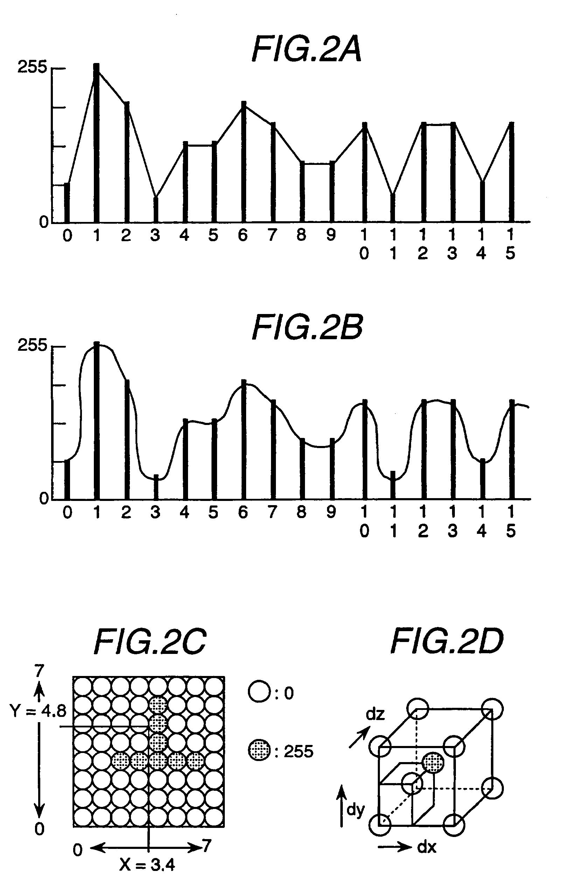

Referring to FIG. 2, there are shown some functions of a semiconductor memory having arithmetic function practiced as one embodiment of the present invention. First, FIG. 2 (a) illustrates an example of interpolating a one-dimensional data sequence in a linear (linear equation) manner. The horizontal axis represents addresses while the vertical axis represents data values corresponding to the addresses. Each vertical bar represents the value set in memory while the lines connecting the bars at their tops represent interpolated output. Namely, if the data sequence is stored at addresses 0 through 15 in the semiconductor memory having arithmetic function according to the present invention, specifying an address having a fraction component and reading the data from that address allows reading of linearly interpolated data from before and after the data specified by the address. For example, if 128 is stored at address 9 and 166 at address 10 and a read operation is performed by specifying 9.87 as an address, the semiconductor memory having arithmetic function reads two addresses 9 and 10, which are nearest to the address 9.87, from the memory and interpolates the values of the addresses 9 and 10 by fraction component 0.87 of the specified address, outputting an interpolation result. For linear interpolation, let the integer component of an address be Ti and its fraction component be Tf, then interpolation result ip can be obtained from expression (1), so that, in the above-mentioned example, 161 is outputted.

$$\mathtt{ip = A(Ti) \; x \; (1 - Tf) + A(Ti + 1) \; x \; Tf \; \ldots \; (1)}$$

where, A(x) indicates the value stored at the specified address. Next, FIG. 2 (b) illustrates an example in which the data sequence is interpolated quadratically. For linear interpolation, data between two pieces of data is calculated. For quadratic interpolation, interpolation is performed from the values of continuous three addresses, so that the values can be varied smoothly as shown in the figure. The calculation for the interpolation can be performed by following expression (2) obtained by solving an equation.

$$\mathtt{ip = (A(Ti - 1) \; x \; (Tf - 1) \; x \; Tf}$$
$$\mathtt{+ \; 2 \; x \; A(Ti) \; x \; (1 - Tf) \; x \; (1 + Tf)}$$
$$\mathtt{+ \; A(Ti + 1) \; x \; (1 + Tf) \; x \; Tf)/2 \; \ldots \; (2)}$$

If address 9 is 128, address 10 is 166, and address 11 is 40 and a read operation is performed with an address being 9.87, since the three addresses nearest to address 9.87 are 9, 10, and 11, Ti = 10, Tf = -0.13, so that ip = 170.

FIG. 2 (c) illustrates an example in which a quadratic data sequence is interpolated and an interpolation result is outputted. It is assumed that the memory be accessible by quadratic addresses (coordinates) and data (pixel) for each addresses be eight bits. In the figure, the value of eight pixels of which X and Y coordinates are (2,3), (3,3), (4,3), (5,3), (6,3), (4,4), (4,5) and (4,6) is set to 255 and the other pixels are set to 0. If X = 3.4 and Y = 4.8 are specified and this semiconductor memory having arithmetic function is read, values of pixels of which coordinates are (3,4), (3,5), (4,4), and (4,5) are read for interpolation and an interpolation result is outputted in the case of linear interpolation. If the integer parts and the fraction parts of the coordinates X, Y to be read are TXi, TXf and TYi, TYf, then interpolation result ip can be obtained from expression (3).

$$ip = A(TXi,TYi) \times (1 - TXf) \times (1 - TYf)$$
$$+ A(TXi + 1,TYi) \times TXf \times (1 - TYf)$$
$$+ A(TXi,TYi + 1) \times (1 - TXf) \times TYf$$
$$+ A(TXi + 1,TYi + 1) \times TXf \times TYf \ldots (3)$$

Therefore, in the example of FIG. 2 (c), ip = 102.

FIG. 2 (d) illustrates an example in which a three-dimensional data sequence is interpolated and an interpolation result is outputted. This figure shows an example of linear interpolation. The semiconductor memory having arithmetic function uses eight pixels around a specified coordinate (a dot in the figure) and an offset (dx, dy, dz) from an integer grid to perform interpolation in the same manner as those of the above-mentioned one-dimensional and two-dimensional interpolating operations.

So far, the capability of the semiconductor memory having arithmetic function has been described with attention mainly paid to linear interpolation. Like the above-mentioned expression (2), a weight coefficient for data can be obtained from the fraction component of an address to interpolate values by such higher-degree functions as quadratic and cubic. Further, if the obtained weight coefficient is fixed, a Laplacian filter can be implemented.

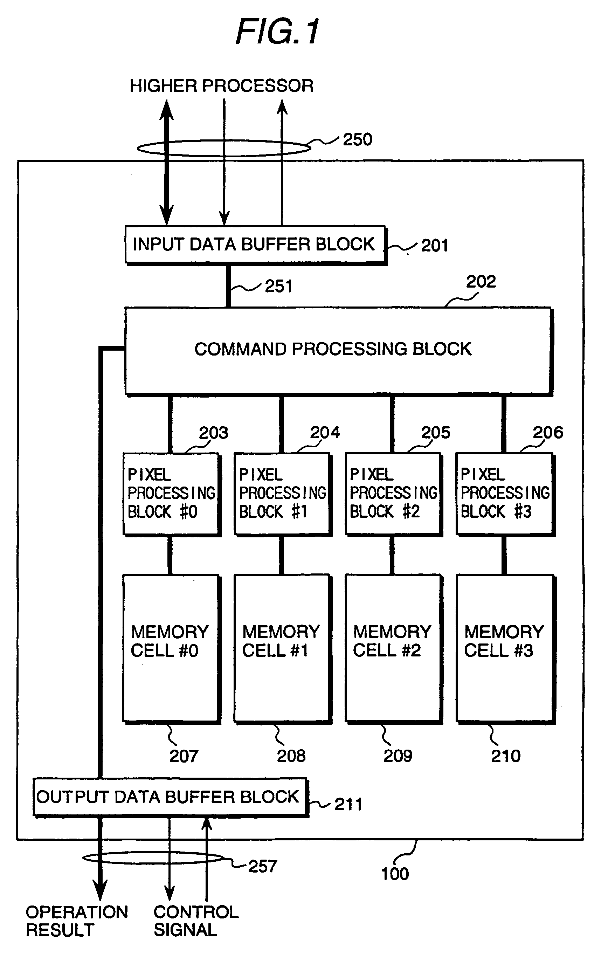

The following describes an internal constitution of the semiconductor memory having arithmetic function with reference to FIG. 1.

A semiconductor memory having arithmetic function 100 comprises an input data buffer block 201 that receives an address, write data, and control-signal transmitting signal line group 250 from a higher processor and buffers an access request coming from the higher processor, a command processing block 202 that receives the buffered access request from the higher processor sent over the signal line group 251, decodes the request, converts the decoded requests into actual memory addresses to control the access of pixel processing blocks 203, 204, 205, and 206 for performing parallel processing for each pixel, and instructs these blocks to perform interpolation, the pixel processing blocks 203, 204, 205, and 206 that reads memory according to the instruction issued from the command processing block 202 to multiply pixel data by a weight coefficient, memory cells 207, 208, 209, and 210 that actually store data, and an output data buffer block 211 that receives a result of the interpolation performed by the command processing block to output the result to outside of the chip.

To interpolate a two-dimensional image, the higher processor stores two-dimensional image data to be stored via the signal line group 250. Next, selection between linear interpolation, quadratic interpolation, and use of a fixed weight coefficient is set to a MOD register (not shown). Then, when an address (coordinates) to be read is set from the signal line group 250, the command processing block 202 calculates addresses to be given to the four pixel processing blocks 203, 204, 205, and 206 and obtains a weight coefficient for each pixel from the fraction component of the specified address. Next, the four pixel processing blocks 203, 204, 205, and 206 read the pixel data of the specified addresses, multiply the pixel data by the specified weight coefficient and return multiplication results to the command processing block 202. The returned multiplication results are added together and an addition result is outputted to the higher processor as the read data via an output data buffer.

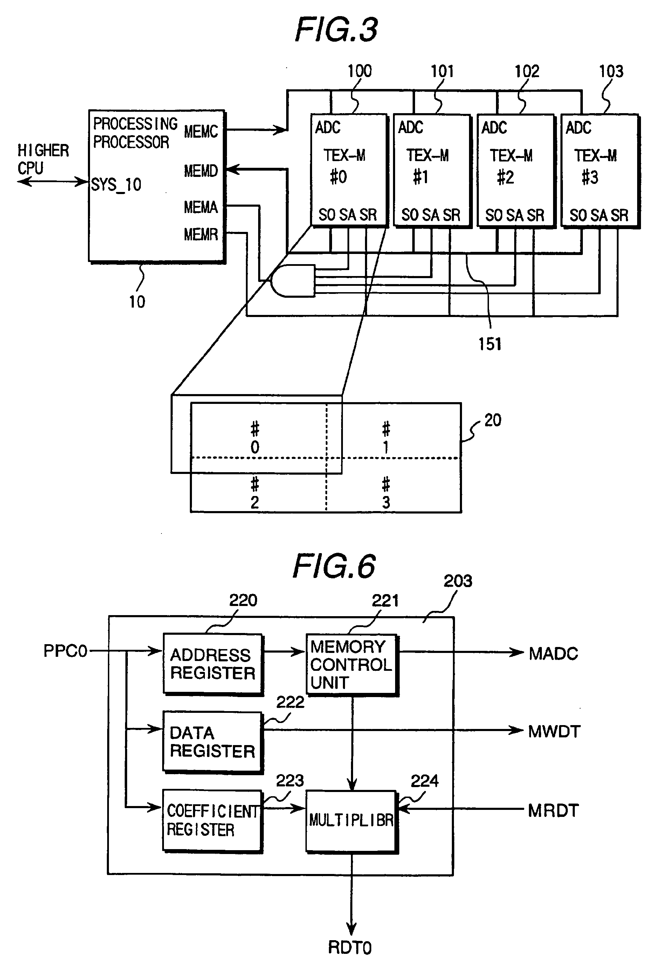

The following describes a constitution of a processing apparatus for performing high-speed processing of a large amount data by use of this semiconductor memory having arithmetic function with reference to FIG. 3. FIG. 3 illustrates a part of an image processing apparatus for performing arithmetic processing based on a two-dimensional original image. A processing processor 10 generates a coordinate of an pixel as instructed from a higher CPU and accesses semiconductor memories having arithmetic function 100, 101, 102, and 103 for reading. In a graphics display apparatus for example, this processing processor 10 holds texture mapping data in the semiconductor memories having arithmetic function 100, 101, 102, and 103, generates a texture data coordinate for every pixel from the coordinate values corresponding to the vertexes of a triangle, reads interpolated pixel information, and writes this information to a frame memory (not shown). The outline of this processing is disclosed in the above-mentioned Japanese Non-examined Patent Publication No. Hei 5-298455.

In FIG. 3, an original image 20 is too large to be stored in one semiconductor memory having arithmetic function. Therefore, the image is divided into four areas with the boundaries overlapped as shown. The processing processor generates an address (coordinates) larger than a space of data stored in each of the memories for access, so that the semiconductor memories having arithmetic function 100, 101, 102, and 103 determine whether output can be made to the respective specified addresses. As a result of the determination, only the semiconductor memory having arithmetic function of which output data is valid is enabled to output interpolation output to a read data bus 151. To specify which of the areas each semiconductor memory having four arithmetic functions 100, 101, 102, 103 are to be related to, a dedicated signal line is provided for each semiconductor memory having arithmetic function. Alternatively, this specification may be made by providing an internal register for area determination. The following briefly describes an operation of the processing apparatus that uses a plurality of semiconductor memories having arithmetic functions 100, 101, 102, 103 as shown in FIG. 3. The processing processor 10 outputs an address signal including a fraction component and a control signal to the semiconductor memories having arithmetic function from an MEMC terminal. When each semiconductor memory having arithmetic function has obtained an interpolation result for the specified address, the memory outputs a signal indicating the end of the processing to an SA terminal and the interpolation result to an SO terminal. However, since only one semiconductor memory having arithmetic function is read for the request address from the processing processor, the SA terminals of the other semiconductor memories having arithmetic function are "valid" and the SO terminals of these memories are put in a high-impedance state. The processing processor reads the read data bus 151 if the result of an AND operation between the outputs of the SA terminals of all memories having arithmetic function is "valid," asserts an MEMR terminal after completion of the reading, and requests next data output. Thus, the reading can be performed from the processing processor in a pipeline manner.

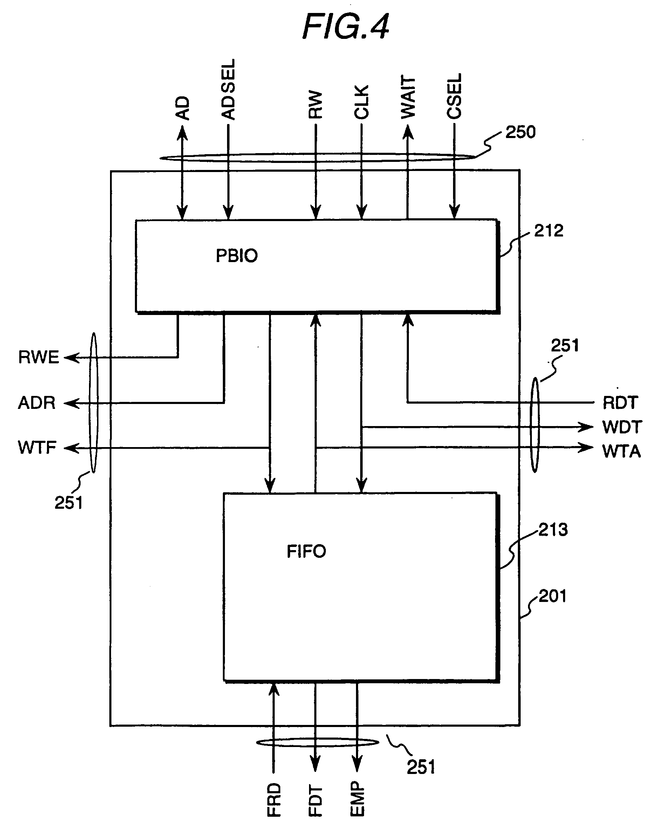

The following describes an internal constitution of the semiconductor memory having arithmetic function with reference to FIGS. 4 through 8.

FIG. 4 illustrates an internal constitution of the input data buffer block 201. The input buffer block 201 is largely composed of a PBIO (Processor Buffer Interface) 212 for receiving an access request from the higher processor and decodes the received request and a FIFO (First In, Fast Out) buffer 213 for buffering the access request. There are four types of accesses to be requested from the higher processor: direct memory access for accessing memory like an ordinary linear address; register access for reading and writing a register internal to the semiconductor memory having arithmetic function; two-dimensional write access for writing a memory cell in two-dimensional space; and interpolation read access for reading interpolation data by specifying a two-dimensional coordinate having a fraction component. Basically, these accesses are classified by address spaces to be specified.

First, the signal line group 250 between the higher processor and the PBIO will be described. A signal line AD provides a signal for transmitting an address and data, a signal line ADSEL provides a signal indicating which of the address and data is set to the signal line AD, a signal line RW provides a signal indicating read access when high and write access when low, a signal line CLK provides a clock signal, a signal line WAIT provides a signal indicating access enable, and a signal line CSEL provides a signal indicating that an access request is valid.

Next, a procedure in which the higher processor performs direct memory access will be described. First, the higher processor specifies the signal line ADSEL, sets memory address information of direct memory access of which most significant two bits are "00" for example for accessing the signal line AD, sets the signal line RW to high level in a read operation, and sets the signal line CSEL to the access enabled state. When the signal line CLK rises with the signal line WAIT in the access enabled state, a read access operation of direct memory access starts and the access information is stored in the FIFO 213. Then, the content of the FIFO 213 is read by the command processing block 202 and after the pixel processing block reads data from a memory cell, the read data is inputted in the PBIO 212 of the input data buffer block 201 via a signal line RDT. On the other hand, when the higher processor sets the data to the signal line ADSEL after address setting, the signal line AD shifts to a state in which the data is outputted from the semiconductor memory having arithmetic function. By reading the data on the signal line AD at a cycle in which the read data comes, the read operation comes to an end. This cycle in which the read data comes is determined by a maximum time of memory cell reading. The cycle is ten and several clocks. This direct memory access is for use in memory check. Therefore, this direct memory access does not especially require a high-speed operation, presenting no problem in the above-mentioned access procedure. The write access of the direct memory access is implemented by writing the signal line RW in the above-mentioned read access. The signal value of the signal line AD with the address set is captured, in the input state, into the PBIO 212 and stored in the FIFO 213 as write data. At this moment, the access by the higher processor comes to an end. Subsequently, in the memory having arithmetic function, this access information is taken by the command processing block out of the FIFO 213 and written to the corresponding memory cell via the pixel processing block.

In register access, access can be made by giving a register space in which the most significant two bits of an address to be specified are "01" for example. When viewed from the higher processor, read access and write access are generally the same except that there is no direct memory access and no waiting time for read data. On the other hand, in the input data buffer block, a register access request is not stored in the FIFO 213 and a register write signal RWE, a register address ADR, and write data WDT are generated to directly control the actual register.

Two-dimensional write access is performed in the same manner as the write operation in direct memory access. When an address is set, the most significant two bits of the address signal are set to "10" for example and the X and Y coordinates are set to the subsequent bits.

In interpolation read access, which is like two-dimensional write access, read access is specified with the signal line RW at high level. For the address to be specified, the most significant two bits of the address signal are set to "11" for example and the X and Y coordinates are set to the subsequent bits. However, this interpolation read access differs from the other access methods in that the interpolated read data is read from the signal line 250 and written to the higher processor, thereby allowing the next cycle with an address set to continuously set an address. Therefore, unless the FIFO 213 is stuffed up, access operations can be performed continuously, realizing high-speed access.

The following describes the operation of the FIFO 213. First, when performing access to the FIFO 213 of the above-mentioned four types of access operations, the PBIO outputs data to be written to the FIFO 213 to the signal line WDT and a signal for instructing a write operation to the FIFO 213 to a signal line WTF. At this moment, if the FIFO 213 is full, a signal line WTA issues an access disabled signal and therefore the FIFO 213 does not accept the write operation. The data to be stored in the FIFO 213 includes an address of direct memory access, data at the write operation, an address and data for two-dimensional write access, an address of interpolation read access, and information for identifying these addresses and data. If any one piece of these data is stored in the FIFO 213, a signal line EMP is negated, upon which data of the first access request is outputted to a signal line FDT. To read this data, the command processing block 202 asserts a signal line FRD. This asserts the signal line EMP when the FIFO 213 is emptied, notifying the command processing block that there is no access request to be outputted.

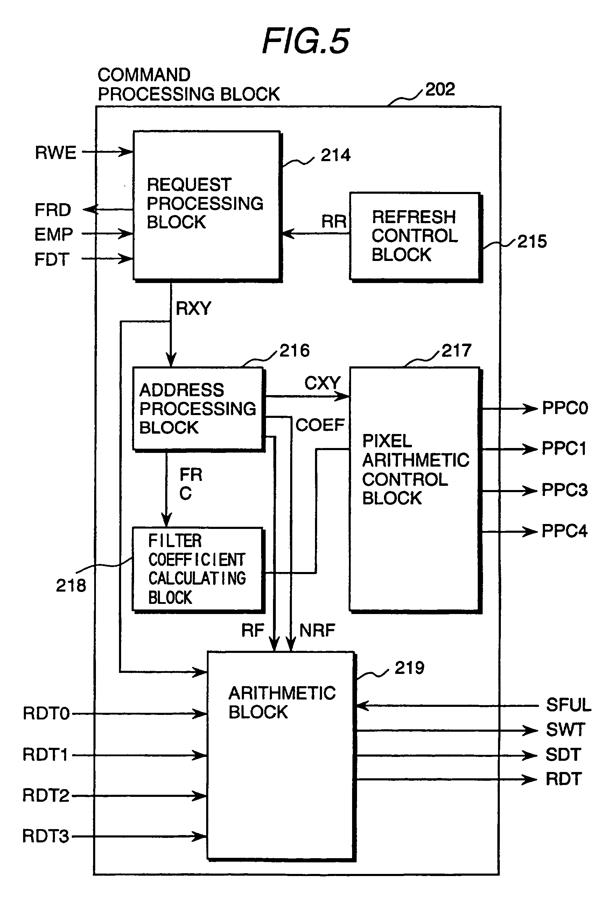

The following describes the command processing block 202 with reference to FIG. 5.

The command processing block 202 receives an access request from the input data buffer block 201, perform arbitration with a refresh cycle request unique to the dynamic memory, controls the pixel processing blocks 203, 204, 205, and 206, calculates read data, and outputs the obtained read data to the output data buffer block.

The command processing block 202 incorporates a refresh control block for periodically outputting a request signal RR for refreshing a memory cell, which is a dynamic memory, a request processing block 214 for performing arbitration between an access request from the input data buffer block 201 and a refresh request from the refresh control block 215 and processing each of these requests in one to several steps, an address processing block 216 for calculating an address to be given to the pixel processing block from the address (coordinates) coming from the request processing block 214 and the type of access and determining whether that coordinate can be calculated from the data stored in the memory cell of the address processing block, a filter coefficient calculating block 218 for calculating from the fraction component of the address a weight coefficient to be multiplied by a pixel, a pixel arithmetic control block 217 for controlling the pixel processing blocks 203, 204, 205, and 206 by the address coming from the address processing block 216 and the weight coefficient coming from the filter coefficient calculating block 218, and an arithmetic block 219 for performing an arithmetic operation on the data obtained by multiplying the pixels outputted from the pixel processing blocks 203, 204, 205, and 206 by the weight coefficient and sending its result to the output data buffer.

First, the refresh control block 215 calculates time in synchronization with the clock and outputs a refresh request signal RR about every 10 $\mu$s.

The request processing block 214 knows by the signal line EMP that an access request has come to the input data buffer block 201, thereby capturing the access request on the signal line FDT. At the same time, by asserting the signal line FRD, the request processing block can put a next access request onto the signal line FDT. Also, the request processing block 214 receives the above-mentioned refresh request signal RR to know that refresh is necessary. First, when the request processing block 214 receives a refresh request signal RR in the idle state, the request processing block counts up an internal refresh counter and outputs the count and a flag indicating the refresh request to a signal line RXY. If there is no refresh request and the signal line EMP is not asserted, the request processing block takes the access request from the signal line FDT and stores the access request into an internal access request register. Then, the request processing block operates as follows according to each access request. First, when a read request of direct memory access comes, the request processing block outputs a specified address and a flag of the read request of direct memory access to the signal line RXY. When a write request of direct memory access comes, the request processing block outputs a specified address and a flag of the write request of direct memory access to the signal line RXY and outputs write data to the signal line RXY in the next cycle. The write data at this point is stored in the FIFO 213 next to the write address. In two-dimensional write access, the request processing block outputs a specified coordinate and a flag of a two-dimensional write access request to the signal line RXY and outputs write data to the signal line RXY in the next cycle. For interpolation read access, the request processing block outputs a specified coordinate and a flag of interpolation read access request to the signal line RXY. At this point, since there are four pixel processing blocks, if four pixels are read for processing, the processing can be made without change; however, if 16 pixels are read for processing for example, control is performed such that the 16 pixels are processed in units four pixels from top to down. To do so, the flag of interpolation read access request includes a value that indicates a number of four-pixel group. In this processing, one interpolation read access is completed in four cycles.

The address processing block 216 knows by the access request flag on the signal line RXY that there is a request, performs address conversion and output to the pixel arithmetic control block 217 accordingly. First, if the access request flag on the signal line RXY indicates a refresh request, the address processing block 216 outputs the address (counter value) and the flag to a signal line CXY without change. The signal line CXY includes access request flag signal lines for the four pixel processing blocks and signal lines for address or data transmission. When issuing a refresh request, the address processing block outputs the refresh request to all signal lines of the four pixel processing blocks in the same manner. Next, if the access request flag on the signal line RXY indicates a direct memory access read operation, the address processing block outputs the address and the flag to the signal line CXY connected to the pixel processing block to which the memory cell corresponding to the specified address is connected. If the access request flag indicates a direct memory access write operation, the address processing block outputs the address and the flag to the signal line CXY connected to the pixel processing block to which the memory cell corresponding to the specified address is connected and outputs write data in the next cycle. If the access request flag on the signal line RXY indicates a two-dimensional write access operation, the address processing block outputs the address and the flag to the signal line CXY connected to the pixel processing block to which the memory cell corresponding to the specified address is connected and, at the same time, outputs write data in the next cycle. If the access request flag on the signal line RXY indicates an interpolation read access operation, the address processing block transfers the fraction part of the address (coordinates) to the filter coefficient calculating block 218 via a signal line FRC and, at the same time, outputs the address and the flag corresponding to each pixel processing block to the signal line CXY. As described above, for interpolation requiring to read more than four pixels, the address processing block outputs the address and the flag to the signal line CXY while changing the addresses corresponding to the pixel processing blocks.

The following shows a relationship between the memory addresses and the coordinates in direct memory access, two-dimensional write access, and interpolation read access. First, the memory addresses are continuously provided in the order of memory cells 207, 208, 209, and 210. Coordinates (0,0) correspond to address 0 of the memory cell 207, coordinates (0,1) correspond to address 0 of the memory cell 208, coordinates (1,0) correspond to address 0 of the memory cell 209, coordinates (1,1) correspond to address 0 of the memory cell 210, and coordinates (2,0) correspond to address 1 of the memory cell 207. Thus, a pixel of which X coordinate is an even number and Y coordinate is an even number corresponds to the memory cell 207, a pixel of which X coordinate is an even number and Y coordinate is an odd number corresponds to the memory cell 208, a pixel of which X coordinate is an odd number and Y coordinate is an even number corresponds to the memory cell 209, and a pixel of which X coordinate is odd number and Y coordinate is an odd number corresponds to the memory cell 210. As with the processing apparatus of FIG. 3 in which the plurality of semiconductor memories having arithmetic function are used by dividing an area, the above-mentioned relationship between addresses and coordinates is relatively the same with offsets attached. Namely, address 0 of the memory 207 corresponds to coordinates (512,0) and address 0 of the memory cell 208 corresponds to coordinates (512,1) for example. These offset values are determined by a signal (not shown) that performs chip area specification, is directly set from outside of the LSI, and is used in the address processing block 216. When the processing apparatus is composed of a plurality of semiconductor memories having arithmetic function such as mentioned above, the address processing block 216 determines where the data for interpolating specified coordinates is located in its own memory cell. If the interpolation is found practicable, the address processing block outputs an access request to the pixel processing block 217 via the signal line CXY as described above and, at the same time, outputs a signal RF indicating the output of the access request to the arithmetic block 219. If the interpolation is found impracticable, the address processing block outputs a signal NRF indicating that the access request is disabled for arithmetic operation to the arithmetic block 219. The determination whether the above-mentioned data for interpolation is located in own memory cell can be easily implemented by a comparator.

The filter coefficient calculating block 218 calculates a weight coefficient to be multiplied by each pixel in interpolation read access. To be more specific, the filter coefficient calculating block calculates weight coefficients shown in the above-mentioned expressions (1), (2), and (3) from the fraction part of coordinates and outputs the calculated coefficients to the pixel arithmetic control block via a signal line COEF. The processing for obtaining weight coefficients can easily be implemented by a multiplier and an adder. Interpolation by a cubic expression requires division by three. In this case, too, the processing can be implemented by multiplication of a constant of 1/3. If the number of digits of a fraction part is small, a coefficient can be obtained by table reference by stored coefficients in memory. Without using the fraction part of coordinates, a Laplacian filter can be implemented in the same procedure as interpolation read access by providing a register for holding a Laplacian filter coefficient.

The pixel arithmetic control block 217 distributes addresses from the address control block 216 for the pixel processing blocks 203, 204, 205, and 206, a flag indicating the type of access, and a weight coefficient COEF for use at interpolation read access to the pixel processing blocks 203, 204, 205, and 206.

The arithmetic block 219 receives the signal RF indicating that a read request has been outputted and, after passing of a certain time, captures read data RDT0 through 3 from the pixel processing blocks 203, 204, 205, and 206 to add the data together. The arithmetic block outputs the addition result to a signal SDT and sets to a signal SWT that the addition result is "valid" and "the addition result is outputted from the semiconductor memory having arithmetic function." If the output data buffer block is stuffed up and therefore no more data can be accepted, a signal SFULL is asserted, so that, at that moment, the state of the arithmetic block 219 must not be changed. Normally, "valid" is set to the SWT, upon which a next arithmetic operation can be started. To perform interpolation from 16 pixels, the addition result is internally held and the output is made at the fourth time, making the SWT "valid." If the signal NRF indicating no interpolation output is asserted in this LSI, the arithmetic result is uncertain and therefore the SWT is set to "valid" and "the interpolation result is not outputted from the semiconductor memory having arithmetic function."

The above-mentioned description is related to an example of interpolation read access. In the case of direct memory access read, the corresponding one from the read data RDT 0 through 3 is outputted to the RDT according to the signal RXY including the specified coordinates.

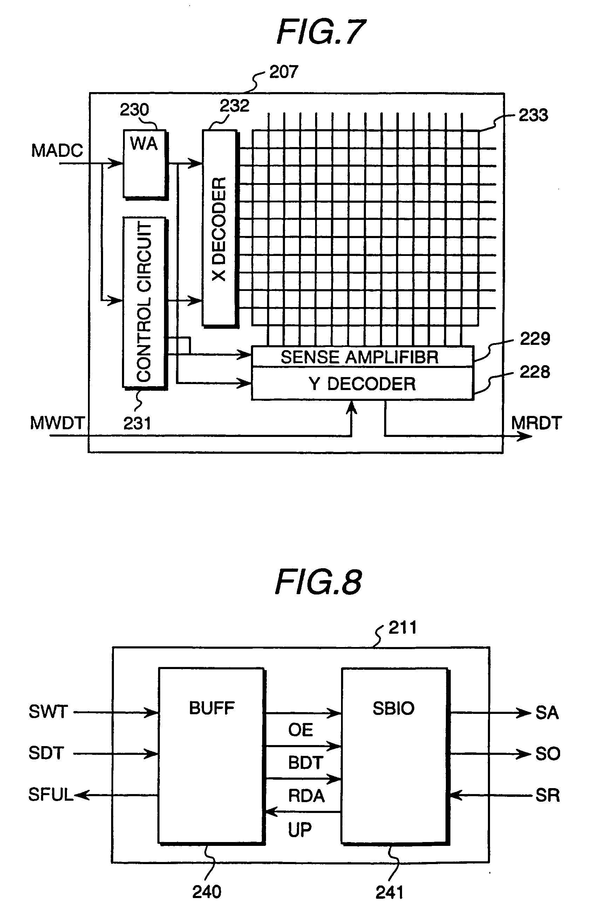

The following describes the pixel processing block 203 with reference to FIG. 6.

First, a signal PPC0, which is the input to the pixel processing bloc, is composed of an address indicating coordinates, a flag indicating an access type, a weight coefficient, and write data for data write access. In every access mode, an address is stored in an address register 220 first and converted by a memory control unit into a memory cell address, which is outputted with a control signal to a signal line MADC. In interpolation read access, a weight coefficient is stored in a coefficient register 223. In direct memory access write and two-dimensional write access, the data to be written after the address is set to the PPC0, so that this write data is stored in a data register.

When a certain time passes after the memory control unit 221 outputs a data read request from a memory cell, the read data is set to a read signal line MRDT. This time is determined by the address for the memory cell. If the address of the data currently read to a sense amplifier 229 is specified, the read data is set after one clock. If the address of data not in the sense amplifier 229 is specified, the read data is set after six clocks.

The read data is multiplied in a multiplier 224 by the value of the coefficient register and the result is passed to the command processing block 202 via a signal RDT0. The pixel processing blocks 204, 205, and 206 have the same constitution as the pixel processing block 203 because the command processing block 202 accesses each pixel processing block with differences in operation taken into consideration.

The following describes the memory cell 207 with reference to FIG. 7.

The memory cell 207 is composed of a register WA 230 for storing address data on the signal MADC, a storage element 233 arranged on a two-dimensional grid, an X decoder 232 for selecting one row of storage elements 233, a sense amplifier 229 for reading data of one row of storage elements 233 and storing the read data, a Y decoder for selectively reading and writing one pixel of data stored in the sense amplifier according to the address held in the register WA230, and a control circuit 231 for controlling the X decoder 232, the sense amplifier 229, and the Y decoder 228 according to the control signal on the signal MADC.

The memory cell shown is the same as the cell of an ordinary dynamic memory and not a special memory cell. The control signal on the signal MADC can be specified with an operation for reading one row of storage elements 233 selected by the X decoder into the sense amplifier 229, an operation for capturing one pixel of data from the data located on the sense amplifier 229 and outputting the captured data to the signal MRDT, an operation for writing the value of a signal MWDT of write data to the sense amplifier 229, and an operation for writing the data of the sense amplifier 229 selected by the X decoder to one row of storage elements 233. According to these specifications, the control circuit 231 controls the X decoder 232, the sense amplifier 229, and the Y decoder 228.

The following describes the output data buffer block 211 with reference to FIG. 8.

The SDT signal, which is data about an interpolation result coming from the command processing block 202, is stored in a buffer BUFF 240 along with flag "output from the semiconductor memory having arithmetic function" according to the "valid" flag indicated by the SWT. This buffer BUFF 240 is a FIFO. Therefore, if no more data can be stored therein, a SFULL signal is asserted. If the buffer BUFF 240 contains data, the buffer asserts a signal RDA and outputs valid data to a BDT and the flag "output from the semiconductor memory having arithmetic function" to a signal OE. When a data update signal UP comes from an output block SBIO 241, the buffer outputs the buffered data to the signals BDT, RDA, and OE.

The output block SBIO 241 is a simple LSI input/output driver. When the OE is asserted, the output block outputs the value of the signal BDT to a signal line SO; when the OE is negated, the output block puts the signal line SO into high-impedance state. Signal lines SA and SR are connected to the RDA and the UP without change via a driver.

Lastly, a processing apparatus for processing a large image by use of a plurality of semiconductor memories having arithmetic function will be described with reference to FIG. 3.

In what follows, an example of image enlargement processing will be shown. First, image data 20 of an original image to be enlarged is stored in the semiconductor memories having arithmetic function 100, 101, 102, and 103 by the higher CPU via the processing processor. At this point, the processing processor 10 gives an integer address (coordinates) and then its data to the signal terminal MEMC in two-dimensional write access, thereby setting the pixel of the image data 20 of the original image to the semiconductor memory having arithmetic function. At this point, each semiconductor memory having arithmetic function determines by the address processing block 216 whether the area is its own area. If the area is found its own area, the semiconductor memory having arithmetic function performs write access from the pixel arithmetic control block 217 to the corresponding memory cell. The relationship between this semiconductor memory having arithmetic function and the image data 20 of the original image is a slightly large area than each of the equally divided areas of the image data 20 of the original image as shown by the extension line drawn from the semiconductor memory having arithmetic function of Fig. 3. Namely, each semiconductor memory having arithmetic function has, in an overlapped manner, pixels around the boundary between the divided areas of the image data 20 of the original image.

The size of the overlapped area depends on the degree of interpolation. In interpolation by a linear expression, the size is one pixel. In interpolation by quadratic and cubic expressions, the size is two pixels. Thus, each semiconductor memory having arithmetic function can read the pixels of an original image for interpolation inside its own LSI.

The following describes the processing for reading given coordinates of the image data 20 of an original image. The processing processor 10 gives an address (coordinates) having a fraction component to the signal terminal MEMC in interpolation read access. This address can be obtained by sequentially adding about 0.77, which is the reciprocal number of 13 if the image is to be enlarged thirteen fold for example. The address thus obtained can be given continuously until a WAIT signal of a signal line group ADC is asserted. Meanwhile, if this interpolation read access is made, the semiconductor memory having arithmetic function causes the address processing block 216 of the command processing block 202 to determine whether the specified address is the address to be outputted by the semiconductor memory having arithmetic function as described before and outputs the interpolation result to the output data buffer block 211. If the address is the address to be outputted by the semiconductor memory having the arithmetic function, the SA terminal of the same is asserted upon obtaining of the interpolation result. If the address is not the address to be outputted, the SA terminal is asserted once for each interpolation read access. The signal of the SA terminal is connected to a MEMA terminal of the processing processor 10, through an AND gate, by which the processing processor 10 can know that the read result for one interpolation read request has been established. If the processing processor 10 captures this data to request a next interpolation read result, asserting a MEMR terminal connected to the SR terminal of each semiconductor memory having arithmetic function outputs the next interpolation read result to the SO terminal.

Repeating the above-mentioned processing provides the pixel data of a new image resulted from enlarging the image data 20 of the original image. The new image thus obtained is written by a terminal not shown of the processing processor to the image memory to be displayed on a CRT or the like.

As described and according to one embodiment, memory access is made inside the LSI chip, so that, if the number of signal lines connected to the higher processor is equal to the signal frequency, the processing speed is increased four times, four being the degree of memory access parallelism, namely the number of pixel processing blocks. Inside the LSI, the processing speed increases still further because of small wiring capacitance. Conversely, to implement the same performance by a prior-art constitution, parallelism of more than four times is required, thereby increasing the equipment size and cost.

The pixel processing blocks having a multiplier in units of pixels are provided and multiplication is performed in parallel, thereby enabling interpolation for image reduction and enlargement at a high speed.

If a plurality of semiconductor memories having arithmetic function are used in order to handle a large image, a circuit is provided for determining that a slightly smaller area than the area of an image stored in each semiconductor memory having arithmetic function is the area to be outputted by that semiconductor memory having an arithmetic function. By this novel constitution, an address space larger than the address space of actually stored data and a small address space between adjacent pieces of data can be set when the semiconductor memories having arithmetic function are viewed from the upper processor.

Thus, the present embodiment has been described mainly with respect to enlargement and reduction of a two-dimensional image. It will be apparent that the same effect can be obtained by the same constitution with respect to a three-dimensional image and a four-dimensional image (the fourth dimension may be time axis or the four-dimensional image may be a plurality of prefiltered three-dimensional images).

By use of the constitution briefly described with reference to the present embodiment, image processing such as the Laplacian filter can be performed.

As described and according to the present invention, an address having fraction component may be specified to the data stored at an integer address, thereby providing the data interpolated at a high speed.

By holding the data of a larger address space than the address space outputted by one semiconductor memory having arithmetic function, data interpolated at a high speed and a low cost may be provided for the data of a huge address space by use of a plurality of semiconductor memories having arithmetic function.

**Claims**

1.  A semiconductor memory having arithmetic function (100) used with a processor, said semi-conductor memory comprising:

    a storage means (207, 208, 209, 210) for holding data corresponding to integer addresses in a continuous N-dimensional space (N being an integer);
    a data arithmetic means (224, 219) for receiving an input fraction address being composed of an integer component which is the N-dimensional integer address and an N-dimensional fraction component for specifying an address between the integer addresses, and for reading the data corresponding to the address indicated by the integer component, and the data before and after the address indicated by the integer component in each dimension, and for performing arithmetical interpolation according to the fraction component;
a memory control unit(221) for controlling the access of data into the storage means;
an output means (211) for outputting the arithmetic result of the data arithmetic means;

**characterised in that**:

the data arithmetic means (224, 219) is arranged to calculate interpolation data corresponding to the continuously inputted fraction address, and output the calculated result; and wherein:
the output means (211) is arranged to output the calculated result, that is calculated by the data arithmetic means, on the output of a signal (SA), which indicates that arithmetic processing of the data arithmetic means has finished and the input of a signal (SR), which indicates that the processor begins to read an arithmetic result.

**2.** A semi-conductor memory having arithmetic function according to claim 1, wherein
said storage means (207, 208, 209, 210) has a plurality of semiconductor memories (100, 101, 102, 103) having an arithmetic function and each being arranged to hold part of the data of another of the plurality of semiconductor memories (100, 101, 102, 103) in a mutually overlapped manner; and
each of the plurality of semiconductor memories (100, 101, 102, 103) has an address determining means for determining whether the address including said N-dimensional fraction component input from the processor (10) is within the range of addresses of data held in said storage means (207, 208, 209, 210).

**Patentansprüche**

**1.** Halbleiterspeicher mit Arithmetikfunktion (100) zur Verwendung mit einem Prozessor, wobei der Halbleiterspeicher aufweist:

eine Speichereinrichtung (207, 208, 209, 210) zum Speichern von Daten, die ganzzahligen Adressen in einem kontinuierlichen N-dimensionalen Raum (wobei N eine ganze Zahl ist) entsprechen,
eine Daten-Arithmetikeinrichtung (224, 219) zum Empfangen einer Eingabeabschnittsadresse, die aus einer ganzzahligen Komponente, die eine N-dimensionale ganzzahlige Adresse ist, und einer N-dimensionalen Abschnittskomponente zum Spezifizieren einer Adresse zwischen den ganzzahligen Adressen zusammengesetzt ist, und zum Lesen der Daten, die der durch die ganzzahlige Komponente angezeigten Adresse entsprechen, und der Daten vor und nach der durch die ganzzahlige Komponente in jeder Dimension angezeigten Adresse, sowie zum Durchführen einer arithmetischen Interpolation gemäß der Abschnittskomponente,
eine Speichersteuereinheit (221) zum Steuern des Datenzugriffs in der Speichereinrichtung,
eine Ausgabeeinrichtung (211) zum Ausgeben des arithmetischen Ergebnisses der Daten-Arithmetikeinrichtung,

**dadurch gekennzeichnet, daß**
die Daten-Arithmetikeinrichtung (224, 219) dazu ausgelegt ist, die Interpolationsdaten zu berechnen, die den kontinuierlich eingegebenen Abschnittsadressen entsprechen, und das berechnete Ergebnis auszugeben, und wobei die Ausgabeeinrichtung (211) dazu ausgelegt ist, das berechnete Ergebnis auszugeben, das durch die Daten-Arithmetikeinrichtung anhand der Ausgabe eines Signals (SA), das anzeigt, daß die Arithmetikverarbeitung der Daten-Arithmetikeinrichtung beendet wurde, und der Eingabe eines Signals (SR), das anzeigt, daß der Prozessor ein arithmetisches Ergebnis zu lesen beginnt, berechnet wird.

**2.** Halbleiterspeicher mit Arithmetikfunktion nach Anspruch 1, wobei
die Speichereinrichtung (207, 208, 209, 210) mehrere Halbleiterspeicher (100, 101, 102, 103) mit Arithmetikfunktion aufweist, die jeweils dazu ausgelegt sind, einen Teil der Daten eines anderen der mehreren Halbleiterspeicher (100, 101, 102, 103) in sich wechselseitig überlappender Weise zu speichern, und
jeder der mehreren Halbleiterspeicher (100, 101, 102, 103) eine Adreßbestimmungseinrichtung aufweist, um festzustellen, ob die Adresse, die die von dem Prozessor (10) eingegebene N-dimensionale Abschnittskomponente aufweist, innerhalb des Adreßbereichs der in der Speichereinrichtung (207, 208, 209, 210) gespeicherten Daten liegt.

**Revendications**

1. Mémoire à semi-conducteurs ayant une fonction arithmétique (100) utilisée avec un processeur, ladite mémoire à semi-conducteurs comportant :

   des moyens de mémorisation (207, 208, 209, 210) pour conserver des données correspondant à des adresses entières dans un espace N-dimensionnel continu (N étant un nombre entier),
   des moyens arithmétiques de données (224, 219) pour recevoir une adresse de fraction d'entrée qui est composée d'un composant entier qui est l'adresse entière N-dimensionnelle et un composant de fraction N-dimensionnel pour spécifier une adresse entre les adresses entières, et pour lire les données correspondant à l'adresse indiquée par le composant entier, et les données avant et après l'adresse indiquée par le composant entier dans chaque dimension, et pour effectuer une interpolation arithmétique conformément au composant de fraction,
   une unité de commande de mémoire (221) pour commander l'accès aux données dans les moyens de mémorisation,
   des moyens de sortie (211) pour délivrer en sortie le résultat arithmétique des moyens arithmétiques de données,

   **caractérisée en ce que :**

   les moyens arithmétiques de données (224, 219) sont conçus pour calculer des données d'interpolation correspondant à l'adresse de fraction entrée en continu, et délivrer en sortie le résultat calculé, et dans laquelle :

   les moyens de sortie (211) sont conçus pour délivrer en sortie le résultat calculé, qui est calculé par les moyens arithmétiques de données, sur la sortie d'un signal (SA), qui indique que le traitement arithmétique des moyens arithmétiques de données est fini et l'entrée d'un signal (SR), qui indique que le processeur commence à lire un résultat arithmétique.

2. Mémoire à semi-conducteurs ayant une fonction arithmétique selon la revendication 1, dans laquelle lesdits moyens de mémorisation (207, 208, 209, 210) ont une pluralité de mémoires à semi-conducteurs (100, 101, 102, 103) ayant une fonction arithmétique et chacune étant conçue pour conserver une partie des données d'une autre mémoire de la pluralité de mémoires à semi-conducteurs (100, 101, 102, 103) d'une manière mutuellement chevauchée, et
   chaque mémoire de la pluralité de mémoires à semi-conducteurs (100, 101, 102, 103) a des moyens de détermination d'adresse pour déterminer si l'adresse incluant ladite entrée de composant de fraction N-dimensionnel provenant du processeur (10) se trouve dans la plage d'adresses de données conservées dans lesdits moyens de mémorisation (207, 208, 209, 210).

# FIG.1

HIGHER PROCESSOR

~250

INPUT DATA BUFFER BLOCK ~201

~251

202

COMMAND PROCESSING BLOCK

203     204     205     206

| PIXEL PROCESSING BLOCK #0 | PIXEL PROCESSING BLOCK #1 | PIXEL PROCESSING BLOCK #2 | PIXEL PROCESSING BLOCK #3 |
|---|---|---|---|
| MEMORY CELL #0 | MEMORY CELL #1 | MEMORY CELL #2 | MEMORY CELL #3 |

207     208     209     210

OUTPUT DATA BUFFER BLOCK ~211

~257

100

OPERATION RESULT     CONTROL SIGNAL

12

## FIG.2A

## FIG.2B

## FIG.2C

## FIG.2D

## FIG.3

## FIG.6

# FIG.4

## FIG.5

COMMAND
PROCESSING BLOCK                                                      202

# FIG.7

# FIG.8